# EUROPEAN PATENT SPECIFICATION

(11) **EP 0 452 588 B1**
(45) Date of publication and mention of the grant of the patent: **27.12.1995**
(21) Application number: 90311836.2
(22) Date of filing: 29.10.1990
(51) Int. Cl.: H01L 27/142, H01L 31/0224, H01L 31/0352

(54) **Solar cell and method for manufacturing the same**
Solarzelle und Verfahren zu ihrer Herstellung
Cellule solaire et sa méthode de fabrication

(30) Priority: 18.04.1990 JP 102633/90
(43) Date of publication of application: 23.10.1991
(73) Proprietor: MITSUBISHI DENKI KABUSHIKI KAISHA, Tokyo (JP)
(72) Inventor: Hayafuji, Norio, Mitsubishi Denki K.K., Optoelectr, Itami-shi, Hyogo-ken (JP)
(74) Representative: Beresford, Keith Denis Lewis

(56) References cited:
- US-A- 4 897 123
- PATENT ABSTRACTS OF JAPAN vol. 12, no. 500 (E-699) 27 December 1988, & JP-A- 63 211773
- PATENT ABSTRACTS OF JAPAN vol. 13, no. 307 (E-787) 13 July 1989, & JP-A- 01 082570
- PATENT ABSTRACTS OF JAPAN vol. 8, no. 44 (E-229)(1481) 25 February 1984, & JP-A- 58 201376
- PATENT ABSTRACTS OF JAPAN vol. 13, no. 307 (E-787) 13 July 1989, & JP-A- 01 082571

## Description

The present invention relates to a method of manufacturing a solar cell battery and a solar cell battery produced thereby, in which degradation of electrical characteristics can be avoided when a plurality of the constituent solar cells are connected together.

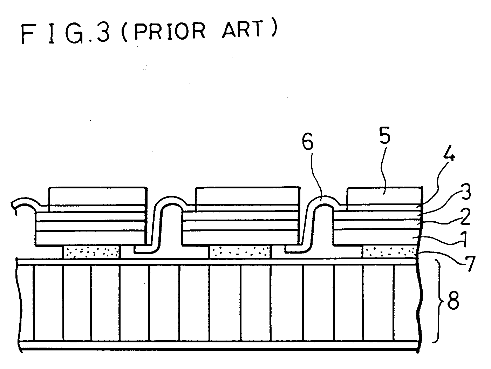

Figure 3 is a sectional view showing a structure of a solar cell battery formed by connecting a plurality of conventional solar cells, which is disclosed in GaAs Interconnect Design and Weld Technology : IEEE PVSC-1985 p.633. In figure 3, each solar cell of the battery comprises an n type GaAs layer 2 and a p type GaAs layer 3 formed on an n type GaAs substrate 1 and a cover glass 5 is attached thereon by a first adhesive 4. In connecting these same type solar cells, an upper electrode of a first solar cell is connected to a lower electrode of a second solar cell by an interconnector 6 and then an upper electrode of the second solar cell is connected to a lower electrode of a third solar cell and so forth. In this way, the upper electrode of one solar cell is connected to the lower electrode of the adjacent solar cell by the interconnector 6, whereby a predetermined number of solar cells are connected in series. Then, these connected plurality of solar cells are arranged and fixed onto a honeycomb board 8 by a second adhesive 7 and then the solar cell battery is completed.

When the conventional solar cell battery is constructed as described above, the constituent solar cells are each separate and the degree of freedom in designing layout is low. In addition, since the p side electrode and the n side electrode are formed on the upper and lower surfaces of each solar cell respectively, it is necessary to connect the upper electrode of one solar cell to the lower electrode of the adjacent solar cell during construction. However, it is difficult to connect two electrodes by the interconnector 6 because there is a large step difference because of the thickness of each solar cell and also the structure of each interconnector 6 results in complication.

In addition, physical stress such as heat generated at the time of connection is applied to each solar cell, often resulting in degradation of the electrical characteristics.

Solar cell batteries which avoid the problem of the above-described step difference and ease connection of the constituent solar cells, are disclosed in, for example, Japanese Patent Laid Open Application No. JP-A-1-82570, and Japanese Patent Laid Open Application No. JP-A-211773, in which a through hole is formed in a substrate and an electrode on an upper surface of the substrate is led to the back surface of the substrate therethrough and then connected to an electrode on the back surface of the substrate. In these cases, however, it is necessary to form an insulating diffusion or to cover the p-n junction part by an insulating film to lead the electrode on the upper surface of the substrate to the back surface, and the formation of that diffusion or insulating film is difficult. Furthermore, it is technically difficult to lead the electrode on the upper surface of the substrate to the back surface thereof.

Japanese Patent Laid Open Application No. JP-A-1-82571 and Patent Abstracts of Japan, Vol. 13, No. 307 (E-787) and US-A-4 897 123 describe the manufacture and structure of a solar cell battery in which each solar cell has a substrate having opposed front and back major surfaces, a crystalline semiconductor layer of a first conductivity type on the front major surface of said substrate, a crystalline semiconductor layer of a second conductivity type on said layer of the first conductivity type, an electrode of the first conductivity type on the back major surface of said substrate;and
an electrode of the second conductivity type having interconnected first and second portions on a front surface of said layer of the second conductivity type and the back major surface of said substrate, respectively; wherein:
said electrode of the first conductivity type of each solar cell is connected to a respective electrode of the second conductivity type of an adjacent one of the plurality of solar cells at the back major surface of said substrate of each solar cell. In the construction of each cell, the substrate, which is of n-type conductivity GaAs, is diffused from each surface with the dopant to form an isolation diffusion extending through the substrate. Each front and back portion of a p-type conductivity electrode is formed each side of this isolation diffusion, front and back. The solar cells are separated from a common substrate wafer; and assembled to produce a solar cell battery in which the respective of the front and back portions of the p-type conductivity electrodes are interconnected and the p-type and n-type conductivity electrodes of adjacent solar cells are connected in series at the back of the assembly.

The present invention is intended as a solution to these problems aforesaid and it is an object of the present invention to provide a method of manufacturing a solar cell battery in which a plurality of solar cells are integrated as part of a common substrate wafer, the wiring structure and connecting work therefor are simple, and further a large physical stress is not applied at the time of connecting work and the electrical characteristics of each cell are not degraded.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

A method of manufacturing a solar cell battery and a solar cell battery, each in accordance with the present invention are defined in claims 1 and 3 of the claims appended. The preamble of claim 3 is based on features which also are known from JP-A-1 82571, just mentioned.

In the accompanying drawings:
Figure 1 shows sectional views each showing a heteroface type GaaAs solar cell portion of a battery at different stages of manufacture as an embodiment of the present invention;
Figure 2 is a sectional view showing one example in which solar cells are integrated on one wafer using the manufacturing method shown in figure 1; and
Figure 3 is a sectional view showing a structure of a solar cell battery comprising a plurality of conventional solar cells.

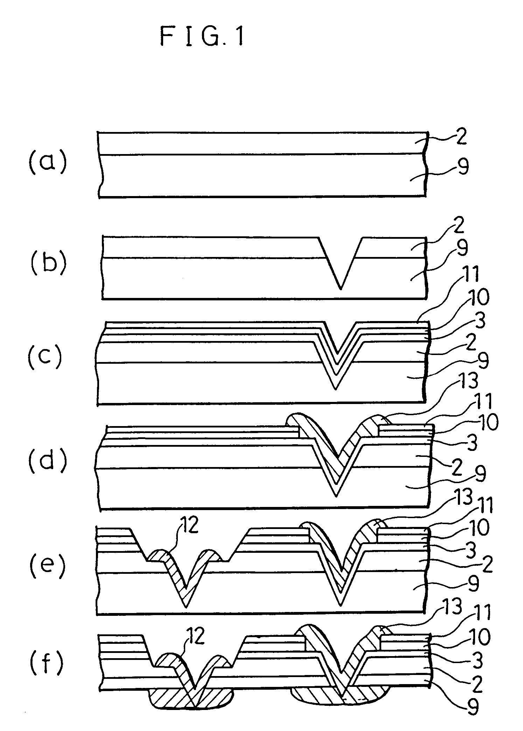

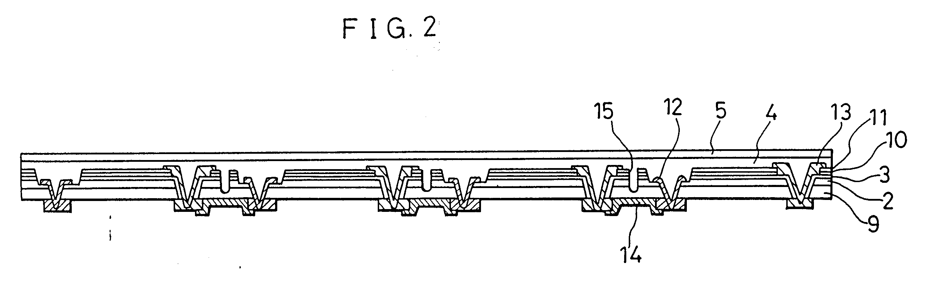

An embodiment of the present invention will be described in detail with reference to figures 1 and 2 of the drawings. The same reference numerals as used in figure 3 designate the same or corresponding parts.

The manufacturing steps therefor will be described hereinafter.
(1) First, an n type GaAs layer 2 is formed on a semi-insulating GaAs substrate 9 by a metal organic chemical vapour deposition method (MOCVD method) (figure 1(a)) and then a part of the n type GaAs layer 2 and the semi-insulating GaAs substrate 9 is selectively etched away and first concavities are formed (figure 1(b)).
(2) Then, a p type GaAs layer 3 and a p type AlGaAs window layer 10 for preventing surface recombination are formed thereon by the MOCVD method and then a reflection preventing film 11 formed of Si₃N₄ is deposited thereon by a photo-assisted CVD method (figure 1(c)).
(3) Then, the p type GaAs layer 3 over each first concavity is exposed by selectively etching the layers 10 and 11 at each first concavity and then a respective p-type conductivity electrode 13 is formed thereon (figure 1(d)).
(4) Then, other parts of the n type GaAs layer 2 and the semi-insulating GaAs substrate 9 are selectively etched away to form second concavities and then a respective n-type conductivity electrode 12 is formed thereon (figure (e)).
(5) Finally, a back surface of the semi-insulating GaAs substrate 9 is etched away or ground so that a part of each n-type conductivity electrode 12 and each p-type conductivity electrode 13 is exposed and then they are reinforced by plating or the like (figure 1 (f)).

Figure 2 is a sectional view showing how the heteroface type GaAs solar cells manufactured as above are integrated on a common substrate wafer. In figure 2, reference numeral 14 designates wiring metal connecting each respective p-type conductivity electrode 13 to a respective n-type conductivity electrode 12. Reference numeral 15 designates a trench formed so as to reach the semi-insulating GaAs substrate 9 to prevent electrical short-circuiting between adjacent solar cells.

As can be seen from figure 2, the wiring metal 14 connects each respective n-type conductivity electrode 12 on the back surface of each respective solar cell to the corresponding respective p-type conductivity electrode 13 on the back surface of the adjacent solar cell.

As described above, insulation of each p-n junction is provided by the semi-insulating GaAs substrate 9, and the electrodes 12, 13 of the first and second conductivity types are formed in concavities in the solar cell active regions, and while connecting a plurality of solar cells, electrodes exposed on the back surface of the substrate 9 are sequentially connected to the respective electrodes of the adjacent solar cells, and finally trenches 15 are provided between the adjacent solar cells so as to reach the semi-insulating GaAs substrate 9. As a result, a plurality of solar cells can be formed on one wafer by a simple fabrication technique. While connecting the plurality of solar cells to constitute a solar cell battery, a step difference is not present at each connector and the wiring structure and the connecting work can be simple and easy. Furthermore, physical stress at the time of connection is reduced.

Although a semi-insulating GaAs substrate 9 is used as the substrate for the solar cell in the above embodiment, the substrate is not limited to this and insulating material such as sapphire or InP or semi-insulating material other than GaAs can be used.

In addition, although GaAs or AlGaAs is used as a material of the active region of the solar cell in the above embodiment, a material such as InP, GaAsP or InGaAsP can be used.

## Claims

1. A method of manufacturing a solar cell battery which method comprises the following steps:
providing a substrate (9) of insulating or semi-insulating material having opposed front and back major surfaces;
forming a crystalline semiconductor layer (2) of a first conductivity type on the front major surface of said substrate (9);
etching said layer (2) of the first conductivity type and said substrate (9) selectively to form first concavities reaching into the body of said substrate (9);
forming a crystalline semiconductor layer (3) of a second conductivity type on the surface of said layer (2) of the first conductivity type and on the respective surfaces of said first concavities exposed by etching;
forming respective electrodes (13) of the second conductivity type on the surface of said layer (3) of the second conductivity type over each first concavity;
etching both said layers (3,2) of the second and first conductivity type, respectively, and said substrate (9), selectively, to form second concavities reaching into the body of said substrate (9);
forming respective electrodes (12) of the first conductivity type on the surfaces of said layer (2) of the first conductivity type and said substrate (9) at the respective surfaces of said second concavities exposed by etching;
removing substrate material by etching or grinding the back major surface of said substrate (9) to expose said electrodes (12,13) of the first and second conductivity types, respectively,
adding electrode material of the first and second conductivity types, respectively, to said electrodes (12,13) of first and second conductivity types, respectively, to reinforce the same, at the back surface of said substrate (9);
connecting said electrodes (12) of the first conductivity type to respective adjacent electrodes (13) of the second conductivity type with a wiring metal (14) at the back surface of said substrate (9); and
forming trenches (15) for insulating and delineating adjacent solar cell portions (2,3,12,13) of the solar cell battery, which trenches (15) extend through both said layers (3,2) of the second and first conductivity types, respectively, and reach said substrate (9).

2. A method of manufacturing a solar cell battery in accordance with claim 1, further comprising the steps of attaching adhesive (4) to the front surface of the battery and placing a cover glass (5) thereon.

3. A solar cell battery comprising a plurality of solar cells (2,3,9,12,13), each solar cell (2,3,9,12,13) having a substrate (9) having opposed front and back major surfaces, a crystalline semiconductor layer (2) of a first conductivity type on the front major surface of said substrate (9), a crystalline semiconductor layer (3) of a second conductivity type on said layer (2) of the first conductivity type, an electrode (12) of the first conductivity type on the back major surface of said substrate (9); and
an electrode (13) of the second conductivity type having interconnected first and second portions on a front surface of said layer (3) of the second conductivity type and the back major surface of said substrate (9), respectively; wherein
said electrode (12) of the first conductivity type of each solar cell (2,3,9,12 and 13) is connected (14) to a respective electrode (13) of the second conductivity type of an adjacent one of the plurality of solar cells (2,3,9,12 and 13) at the back major surface of said substrate (9) of each solar cell (2,3,9,12 and 13);
which solar cell battery is characterised in that:
said substrate (9) of each solar cell (2,3,9,12 and 13) is a substrate (9) common to the plurality of solar cells (2,3,9,12 and 13) and is of insulating or semi-insulating material;
said solar cells (2,3,9,12 and 13) are delineated by trenches (15), for insulation, which trenches (15) extend through both said layers (3,2) of the second and first conductivity types, respectively, and reach said substrate (9);
each said electrode (12) of the first conductivity type extends through said substrate (9) and contacts said layer (2) of first conductivity type of a respective one of said plurality of solar cells (2,3,9,12 and 13); and
each said electrode (13) of the second conductivity type extends through said substrate (9) and contacts said layer (3) of the second conductivity type of a respective one of said plurality of solar cells (2,3,9,12 and 13), which layer (3) of the second conductivity type lies between each said electrode (13) of the second conductivity type and both said substrate (9) and said layer (2) of the first conductivity type in a respective concavity therein.

4. A solar cell battery in accordance with claim 3, wherein there is adhesive (4) at the front surface of the battery and a cover glass (5) is located thereon.

5. A solar cell battery in accordance with claims 3 or 4, wherein said substrate (9) is a semi-insulating GaAs substrate and said layers (2 and 3) of first and second conductivity type are epitaxial crystal layers of n type and p type GaAs, respectively.

## Patentansprüche

1. Verfahren zur Herstellung einer Solarzellenbatterie, wobei das Verfahren die folgenden Schritte aufweist:
das Vorsehen eines Substrats (9) aus isolierendem oder halbisolierendem Material mit vorderer und hinterer Hauptfläche, die entgegengesetzt zueinander liegen,
das Ausbilden einer kristallinen Halbleiterschicht (2) eines Typs mit erster Leitfähigkeit auf der vorderen Hauptfläche des Substrats (9),
das auswählende Ätzen der Schicht (2) des Typs mit erster Leitfähigkeit und des Substrats (9), um erste Höhlungen auszubilden, die in den Körper des Substrats (9) reichen,
das Ausbilden einer kristallinen Halbleiterschicht (3) eines Typs mit zweiter Leitfähigkeit auf der Oberfläche der Schicht (2) des Typs mit erster Leitfähigkeit und auf den jeweiligen Oberflächen der ersten Höhlungen, die durch Ätzen freigelegt sind,
das Ausbilden jeweiliger Elektroden (13) des Typs mit zweiter Leitfähigkeit auf der Oberfläche der Schicht (3) des Typs mit zweiter Leitfähigkeit über jeder ersten Höhlung,
das auswählende Ätzen der Schichten (3, 2) der Typen mit zweiter bzw. erster Leitfähigkeit und des Substrats (9), um zweite Höhlungen auszubilden, die in den Körper des Substrats (9) reichen,
das Ausbilden jeweiliger Elektroden (12) des Typs mit erster Leitfähigkeit auf den Oberflächen der Schicht (2) des Typs mit erster Leitfähigkeit und des Substrats (9) an den jeweiligen Oberflächen der zweiten Höhlungen, die durch Ätzen freigelegt sind,
das Entfernen von Substratmaterial durch Ätzen oder Schleifen der hinteren Hauptfläche des Substrats (9), um die Elektroden (12, 13) der Typen mit erster bzw. zweiter Leitfähigkeit freizulegen,
das Zufügen von Elektrodenmaterial von den Typen mit erster bzw. zweiter Leitfähigkeit zu den Elektroden (12,13) der Typen mit erster bzw. zweiter Leitfähigkeit zum Verstärken von diesen an der hinteren Fläche des Substrats (9),
das Verbinden der Elektroden (12) des Typs mit erster Leitfähigkeit mit jeweiligen benachbarten Elektroden (13) des Typs mit zweiter Leitfähigkeit über ein Verdrahtungsmetall (14) an der hinteren Fläche des Substrats (9) und
das Ausbilden von Gräben (15) zum Isolieren und Beschreiben benachbarter Solarzellenabschnitte (2, 3, 12, 13) der Solarzellenbatterie, wobei sich die Gräben (15) durch beide Schichten (3, 2) der Typen mit zweiter bzw. erster Leitfähigkeit erstrecken und das Substrat (9) erreichen.

2. Verfahren zur Herstellung einer Solarzellenbatterie nach Anspruch 1, das ferner die Schritte des Aufbringens eines Klebemittels (4) auf die vordere Fläche der Batterie und das Positionieren eines Abdeckglases (5) auf diesem beinhaltet.

3. Solarzellenbatterie, die eine Vielzahl von Solarzellen (2, 3, 9, 12, 13) aufweist, wobei jede Solarzelle (2, 3, 9, 12, 13) aufweist: ein Substrat (9) mit vorderer und hinterer Hauptfläche, die entgegengesetzt zueinander liegen, eine kristalline Halbleiterschicht (2) eines Typs mit erster Leitfähigkeit auf der vorderen Hauptfläche des Substrats (9), eine kristalline Halbleiterschicht (3) eines Typs mit zweiter Leitfähigkeit auf der Schicht (2) des Typs mit erster Leitfähigkeit, eine Elektrode (12) des Typs mit erster Leitfähigkeit auf der hinteren Hauptfläche des Substrats (9) und
eine Elektrode (13) des Typs mit zweiter Leitfähigkeit, die erste und zweite Abschnitte, die miteinander verbunden sind, auf einer vorderen Fläche der Schicht (3) des Typs mit zweiter Leitfähigkeit bzw. der hinteren Hauptfläche des Substrats (9) aufweist, wobei
die Elektrode (12) des Typs mit erster Leitfähigkeit jeder Solarzelle (2, 3, 9, 12, 13) mit einer jeweiligen Elektrode (13) des Typs mit zweiter Leitfähigkeit einer benachbarten der Vielzahl von Solarzellen (2, 3, 9, 12, 13) an der hinteren Hauptfläche des Substrats (9) jeder Solarzelle (2, 3, 9, 12, 13) verbunden (14) ist,
wobei die Solarzellenbatterie dadurch gekennzeichnet ist, daß
das Substrat (9) jeder Solarzelle (2, 3, 9, 12, 13) ein Substrat (9) ist, daß der Vielzahl von Solarzellen (2, 3, 9, 12, 13) gemeinsam ist, und aus einem isolierenden oder halbisolierenden Material ist,
die Solarzellen (2, 3, 9, 12, 13) durch Gräben (15) zur Isolierung beschrieben sind, wobei sich die Gräben (15) durch beide Schichten (3, 2) der Typen mit zweiter bzw. erster Leitfähigkeit erstrecken und das Substrat (9) erreichen,
jede Elektrode (12) des Typs mit erster Leitfähigkeit sich durch das Substrat (9) erstreckt und die Schicht (2) des Typs mit erster Leitfähigkeit einer jeweiligen der Vielzahl von Solarzellen (2, 3, 9, 12, 13) berührt und
jede Elektrode (13) des Typs mit zweiter Leitfähigkeit sich durch das Substrat (9) erstreckt und die Schicht (3) des Typs mit zweiter Leitfähigkeit einer jeweiligen der Vielzahl von Solarzellen (2, 3, 9, 12, 13) berührt, wobei die Schicht (3) des Typs mit zweiter Leitfähigkeit zwischen der Elektrode (13) des Typs mit zweiter Leitfähigkeit und sowohl dem Substrat (9) als auch der Schicht (2) des Typs mit erster Leitfähigkeit in einer entsprechenden Höhlung in diesen liegt.

4. Solarzellenbatterie nach Anspruch 3, wobei auf der vorderen Fläche der Batterie ein Klebemittel (4) vorhanden ist und sich ein Abdeckglas (5) darauf befindet.

5. Solarzellenbatterie nach Anspruch 3 oder 4, wobei das Substrat (9) ein halbisolierendes GaAs-Substrat ist und die Schichten (2, 3) des Typs mit erster bzw. zweiter Leitfähigkeit epitaxiale Kristallschichten aus GaAs vom n-Typ bzw. vom p-Typ sind.

## Revendications

1. Procédé de fabrication d'une batterie des cellules solaires, lequel procédé comprend les étapes suivantes :
réaliser un substrat (9) en matériau isolant ou semi-isolant ayant des surfaces principales avant et arrière;
former une couche semi-conductrice crystalline (2) d'un premier type de conductivité sur la surface principale avant dudit substrat (9);
attaquer ladite couche (2) du premier type de conductivité et ledit substrat (9) sélectivement pour former des premières concavités arrivant dans le corps dudit substrat (9);
former une couche semi-conductrice cristalline (3) d'un second type de conductivité sur la surface de ladite couche (2) du premier type de conductivité et sur les surfaces respectives desdites premières concavités exposées par attaque;
former des électrodes respectives (13) du second type de conductivité sur la surface de ladite couche (3) du second type de conductivité sur chaque première concavité;
attaquer à la fois lesdites couches (3, 2) respectivement des second et premier types de conductivité et ledit substrat (9), sélectivement, pour former des secondes concavités arrivant dans le corps dudit substrat (9);
former des électrodes respectives (12) du premier type de conductivité sur les surfaces de ladite couche (2) du premier type de conductivité et ledit substrat (9) aux surfaces respectives desdites secondes concavités exposées par attaque;
retirer du matériau de substrat en attaquant ou polissant la surface principale arrière dudit substrat (9) pour exposer lesdites électrodes (12, 13) respectivement des premier et second types de conductivité,
rajouter du matériau d'électrode respectivement des premier et second types de conductivité auxdites électrodes (12, 13) respectivement des premier et second types de conductivité pour renforcer celles-ci, à la surface arrière dudit substrat (9);
relier lesdites électrodes (12) du premier type de conductivité aux électrodes adjacentes respectives (13) du second type de conductivité par un métal de câblage (14) à la surface arrière dudit substrat (9); et
former des tranchées (15) pour isoler et dessiner des portions de cellules solaires adjacentes (2, 3, 12, 13) de la batterie de 'cellules solaires, lesquelles tranchées (15) s'étendent à travers à la fois lesdites couches (3, 2) respectivement des second et premier types de conductivité, et atteindre ledit substrat (9).

2. Procédé de fabrication d'une batterie de cellules solaires selon la revendication 1, comprenant de plus les étapes de fixer un adhésif (4) à la surface avant de la batterie et placer sur celle-ci un verre de recouvrement (5).

3. Batterie de cellules solaires comprenant une pluralité de cellules solaires (2, 3, 9, 12, 13), chaque cellule solaire (2, 3, 9, 12, 13) ayant un substrat (9) ayant des surfaces principales avant et arrière opposées, une couche semi-conductrice cristalline (2) d'un premier type de conductivité sur la surface principale avant dudit substrat (9), une couche semi-conductrice cristalline (3) d'un second type de conductivité sur ladite couche (12) du premier type de conductivité, une électrode (2) du premier type de conductivité sur la surface principale arrière dudit substrat (9); et
une électrode (13) du second type de conductivité ayant des première et seconde portions interconnectées sur une surface avant de ladite couche (3) du second type de conductivité et la surface principale arrière dudit substrat (9), respectivement; où
ladite électro-de (12) du premier type de conductivité de chaque cellule solaire (2, 3, 9, 12 et 13) est reliée (14) à une électrode respective (13) du second type de conductivité de l'une adjacente de la pluralité de cellules solaires (2, 3, 9, 12 et 13) à la surface principale arrière dudit substrat (9) de chaque cellule solaire (2, 3, 9, 12 et 13);
laquelle batterie de cellules solaires est caractérisée en ce que :
ledit substrat (9) de chaque cellule solaire (2, 3, 9, 12 et 13) est un substrat (9) commun à la pluralité de cellules solaires (2, 3, 9, 12 et 13) et est en matériau isolant ou semi-isolant;
lesdites cellules solaires (2, 3, 9, 12 et 13) sont dessinées par des tranchées (15) pour isolation, lesquelles tranchées (15) s'étendent à travers à la fois lesdites couches (3, 2) respectivement des second et premier types de conductivité, et atteignent ledit substrat (9);
chaque électrode (12) du premier type de conductivité s'étend à travers ledit substrat (9) et contacte ladite couche (2) du premier type de conductivité de l'une respective de ladite pluralité des cellules solaires (2, 3, 9, 12 et 13); et
chaque électrode (13) du second type de conductivité s'étend à travers ledit substrat (9) et contacte ladite couche (3) du second type de conductivité de l'une respective de la pluralité des cellules solaires (2, 3, 9, 12 et 13), laquelle couche (3) du second type de conductivité s'étend entre chaque électrode (13) du second type de conductivité et à la fois ledit substrat (9) et ladite couche (2) du premier type de conductivité dans une concavité respective dans celles-ci.

4. Batterie de cellules solaires selon la revendication 3, dans laquelle il y a un adhésif (4) à la surface avant de la batterie et un verre de recouvrement (5) est situé sur celui-ci.

5. Batterie de cellules solaires selon la revendication 3 ou 4, dans laquelle le substrat précité (9) est un substrat semi-isolant en GaAs et les couches précitées (2, 3) des premier et second types de conductivité sont des couches cristallines épitaxiales en GaAs respectivement du type n et du type p.
